# EUROPEAN PATENT APPLICATION

(11) **EP 0 738 925 A2**
(43) Date of publication of application: **23.10.1996**
(21) Application number: 96301227.3
(22) Date of filing: 23.02.1996
(51) Int. Cl.: G03F 1/08, G03F 1/14

(54) **Mask for adjusting line width of photoresist pattern**

(30) Priority: 21.04.1995 KR 9509454
(71) Applicant: SAMSUNG ELECTRONICS CO., LTD., Suwon-city, Kyungki-do 441-373 (KR)
(72) Inventor: Han, Woo-sung, Suwon-city, Kyungki-do (KR); Sohn, Chang-jin, Seoul (KR)
(74) Representative: Lawrence, Richard Anthony

(57) **Abstract**

A mask used in photolithography includes a transparent substrate, a light-shielding pattern (31) for defining a transmitting region on the transparent substrate, and a transmittance adjusting film pattern (32) added on a portion of a transmitting region for decreasing transmittance of a first transmitting part for transmission of light to a first region of a substrate with respect to the transmittance of a second transmitting part for transmission of light to a second region of the substrate, the mask being adapted for use when the thickness of photoresist in the second region is thicker than that in the first region on the semiconductor substrate. A pattern for use in a highly integrated semiconductor device can be formed by adjusting the light intensity.

## Description

The present invention relates to a mask, and, more particularly, to a mask for adjusting line width of a photoresist pattern according to position on a semiconductor device.

As integration of semiconductor devices is increased, pattern size gradually becomes smaller. Consequently, unevenness of a surface of the semiconductor device becomes more pronounced with increased integration in a limited space. Accordingly, when photoresist is coated on a semiconductor substrate in a pattern formation process, the thickness of the coated photoresist varies sharply according to the position of the pattern, because of the prominent unevenness of the substrate.

Firstly, a step of coating the uneven semiconductor substrate with the photoresist will be described in detail.

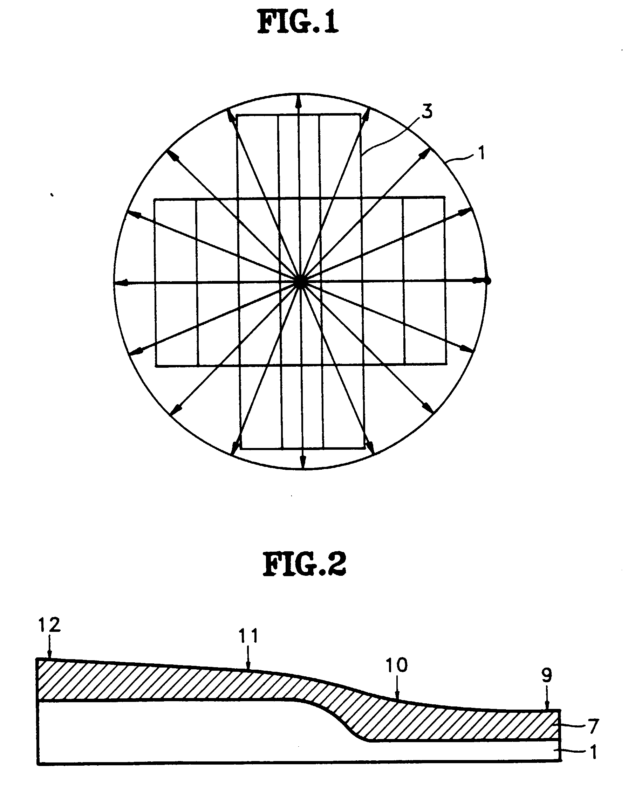

FIG. 1 illustrates the above coating step, which relate to both the present invention and conventional processes.

Specifically, when photoresist is coated on a semiconductor substrate 1 where chips 3 are regularly arrayed in a pattern formation process, the photoresist is coated evenly on the surface of semiconductor substrate 1. It is spread radially, as indicated by the arrows in FIG. 1, since in a normal process semiconductor substrate 1 rotates.

FIG. 2 is a cross-section of semiconductor substrate 1 coated according to Fig. 1 with the photoresist around an uneven region.

Here, when the photoresist is coated on semiconductor substrate 1 having unevenness produced by a previously formed pattern, the coated surface of photoresist 7 becomes relatively planar. However, the coated photoresist has varying thickness according to the position on the substrate due to the sharp change of the relief (degree of unevenness) around the corners of the lower pattern. That is, as shown in FIG. 2, when compared with the thickness of the photoresist on plane surfaces 9 and 12, the thickness of the photoresist on the sunken portion 10 of the uneven region is greater, and that of the photoresist on protruding portion 11 of the uneven region is less.

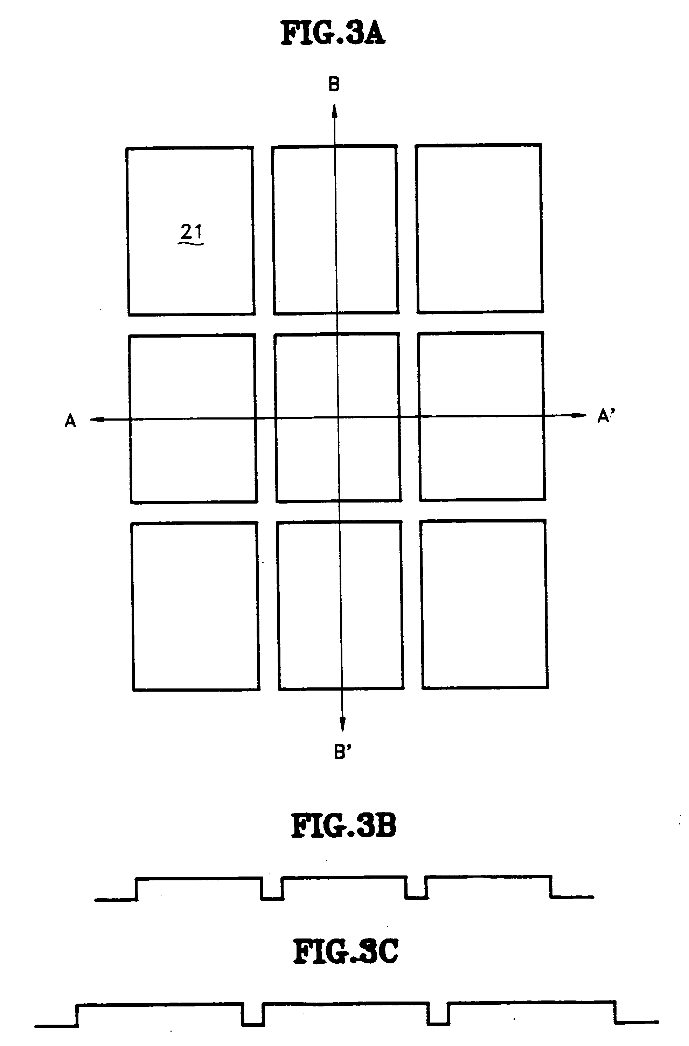

FIGS. 3A to 3D are views illustrating a semiconductor substrate according to Fig. 2 exhibiting regularly formed unevenness being coated with the photoresist.

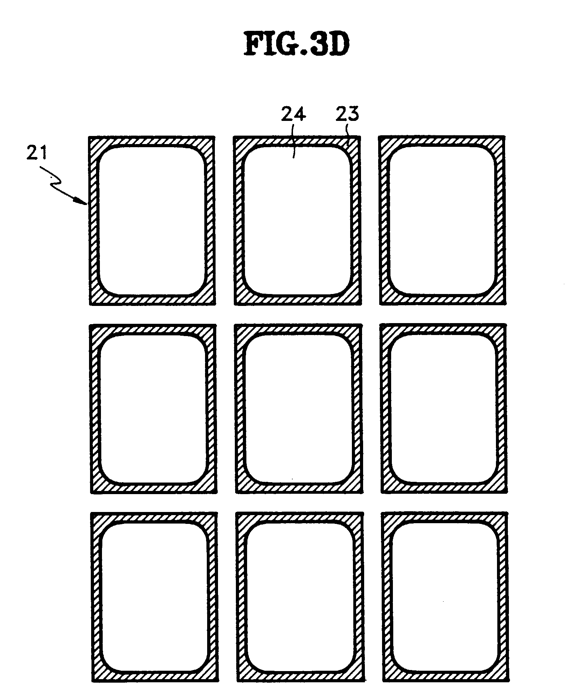

In this case, since a variety of patterns are stacked atop semiconductor substrate 1 for fabrication of a semiconductor device, and chips 3 are arrayed regularly on semiconductor substrate 1 as shown in FIG. 1, the unevenness generated by the lower pattern becomes regular. Accordingly, blocks 21 having a pattern of the same form are arrayed regularly, and the unevenness is regularly generated as shown in FIGS. 3B and 3C which are sections taken along the line A-A' and B-B' of FIG. 3A, respectively. When the photoresist is coated on a semiconductor substrate 1 exhibiting such unevenness, a portion marked as a first region 23 is formed along the edge of blocks 21 as shown in FIG. 3D. First region 23 is a portion where the thickness of the coated photoresist is thinner than that of a second region 24 according to the description of FIG. 2.

The formation of a photoresist pattern using a conventional method will now be described, for a layer having a thickness of photoresist varying according to position, as described above. Here, the photoresist shown in the following description is assumed to be the positive type.

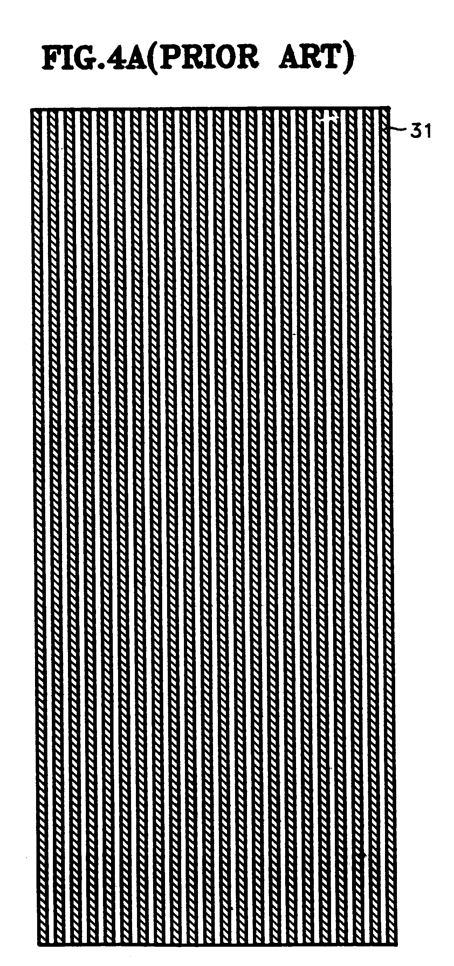

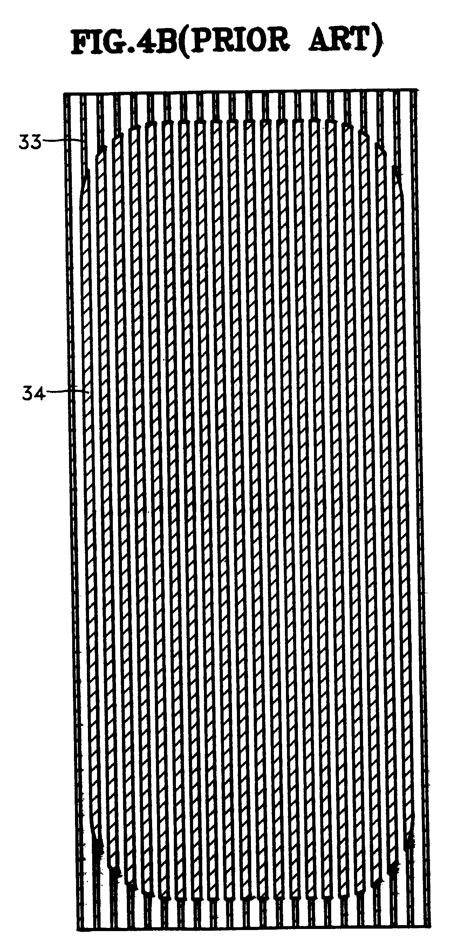

FIGS. 4A and 4B are views illustrating a photolithography procedure according to the conventional technique.

FIG. 4A shows a mask having a pattern form to be applied to block 21 of FIG. 3D. The mask has a constant line width on a transparent substrate and is formed in a regularly arrayed shielding pattern 31. When the employed photoresist is the positive type and block 21 is to be exposed with constant illumination and developed, the photoresist pattern of FIG. 4B is formed, since the thickness of the photoresist is thin in first region 23. That is, the line width of a first region pattern 33 formed around first region 23 where the thickness of the photoresist is thin is smaller than that of second region pattern 34 formed around second region 24.

The conventional method for forming the pattern has disadvantages in that the photoresist pattern does not maintain constant line width as the shielding pattern formed on the mask, and the line width of the first region pattern becomes narrow in the first region where the thickness of the photoresist is thin. Further, such variations in line width cannot be tolerated when the pattern of a semiconductor device is very small. In more severe cases, the pattern becomes excessively narrow, crooked or even severed.

A similar result occurs when the light intensity for exposure is larger in a portion having greater lens aberration in an exposure apparatus. The line width of the photoresist pattern then varies, so that some portions thereof become as narrow as that of the first region pattern.

To solve the above problems, it is an object of the present invention to provide a mask for adjusting line width of a photoresist pattern according to position on a semiconductor device.

Accordingly, to achieve the above object, there is provided a mask used in photolithography, comprising: a transparent substrate; a light-shielding pattern for defining a transmitting region on the transparent substrate; and a transmittance adjusting film pattern disposed in a portion of a transmitting region for increasing transmittance of a second transmitting region to be transferred to a second region compared with a first transmitting region to be transferred to a first region, when the thickness of photoresist in the second region is thicker than that in the first region on the semiconductor substrate where the light-shielding pattern is transferred.

To achieve the above object, there is also provided a mask used in photolithography comprising: a transparent substrate; a light-shielding pattern for defining a transmitting region on the transparent substrate; and a transmittance adjusting film pattern for reducing transmittance of a transmitting region being transferred to a semiconductor substrate through a portion having greater lens aberration of an exposing apparatus.

It is preferred in the present invention that the transmittance of the transmittance adjusting film pattern is congruous or variable between 3-97% according to the position on the mask, and that transmittance adjusting film pattern is formed of a material selected from the group consisting of chromium (Cr), molybdenum (Mo), MoSi, MoSiO, MoSiON, CrO, CrON, amorphous carbon, dyed organic spin-on glass (SOG) and photoresist.

Specific embodiments of the invention are described in detail below, with reference to the attached drawings, in which:
FIG. 1 is a view illustrating the spread direction of a photoresist coating on a semiconductor device, which relates both to the present invention and conventional recesses;
FIG. 2 is a section of a semiconductor substrate being coated according to FIG. 1 with the photoresist around an uneven region;
FIGS. 3A-3D are views illustrating a semiconductor substrate according to Fig. 2 being coated with photoresist and exhibiting unevenness formed regularly;
FIGS. 4A and 4B are views illustrating a photolithography according to a conventional method;
FIG. 5A is a view showing a mask used in a first embodiment of the present invention;
FIG. 5B is a view showing a photoresist pattern formed by using the mask of FIG. 5A;
FIGS. 6A-6C are views for explaining a method of adjusting line width change of a photoresist pattern caused by lens aberration of an exposing apparatus according to the present invention;
FIGS. 7A and 7B are views for comparing the conventional method with an embodiment of the present invention with respect to unevenness having the structure shown in FIG. 2; and
FIGS. 8A and 8B are graphs indicating the light intensity and line width change of photoresist pattern in conventional cases and for embodiments of the present invention, respectively.

The present invention utilizes the feature that line width of a photoresist pattern varies according to the change in light intensity. Accordingly, the above problem can be solved by exposing photoresist with light intensity adjusted to correspond to each unevenness. In particular, the light intensity for exposure can be adjusted easily by forming a transmittance adjusting film pattern in a transmitting region of a portion where light intensity is to be adjusted in a mask used for pattern formation.

### <First Embodiment>

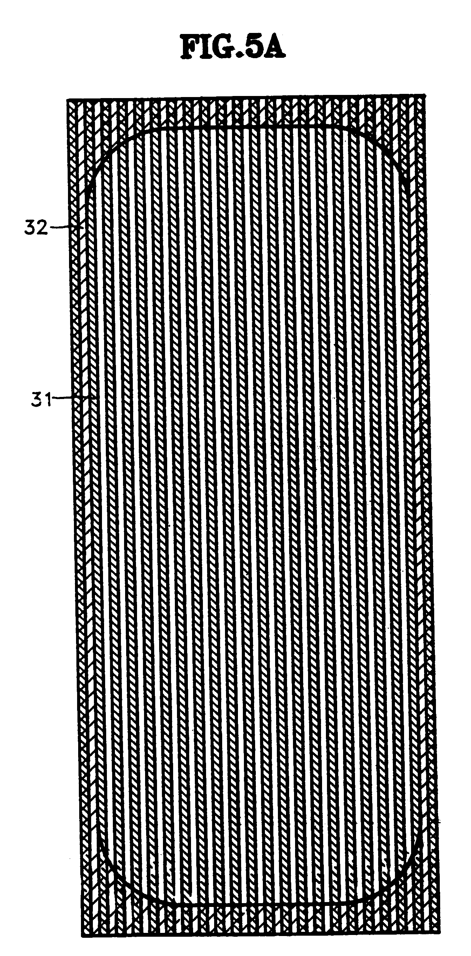

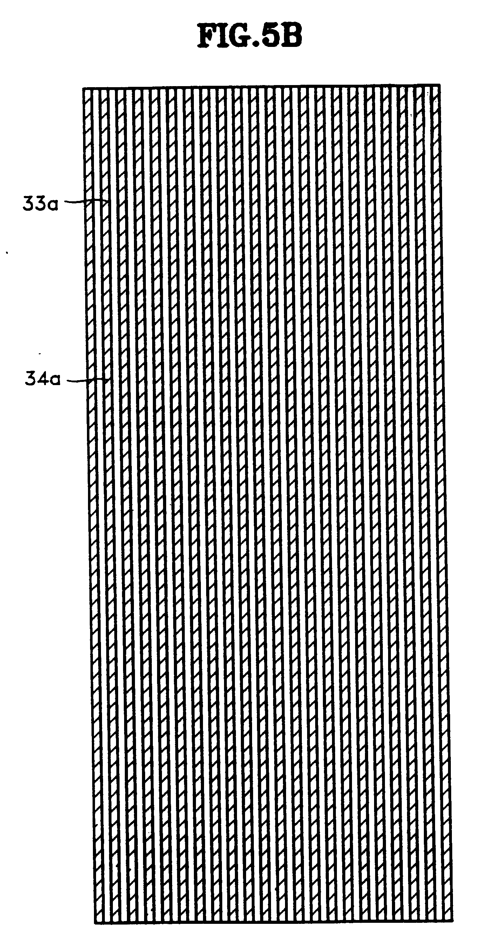

FIG. 5A shows a mask used in a first embodiment of the present invention, and FIG. 5B is a photoresist pattern formed by using the mask.

In this case, when photoresist is coated as shown in FIG. 3D, the mask used in the first embodiment for pattern formation includes shield pattern 31 and transmittance adjusting film pattern 32. Transmittance adjusting film pattern 32 has a function of reducing the light intensity exposing a first region 23 of FIG. 3D. When a semiconductor substrate coated with photoresist as in FIG. 3D is exposed using the mask, a photoresist pattern having closely consistent line width is formed as shown in FIG. 5B. Transmittance adjusting film pattern 32 is not restricted here to the shape of first region 23, and transmittance may be selected between 3-97%, as required. That is, the line width change of the photoresist pattern formed by using the mask can be adjusted within an allowable range in designing a semiconductor device. Besides photoresist material, transmittance adjusting film pattern 32 may be formed of chromium (Cr), molybdenum (Mo), MoSi, MoSiO, MoSiON, CrO, CrON, amorphous carbon, or dyed organic spin-on glass (SOG).

### <Second Embodiment>

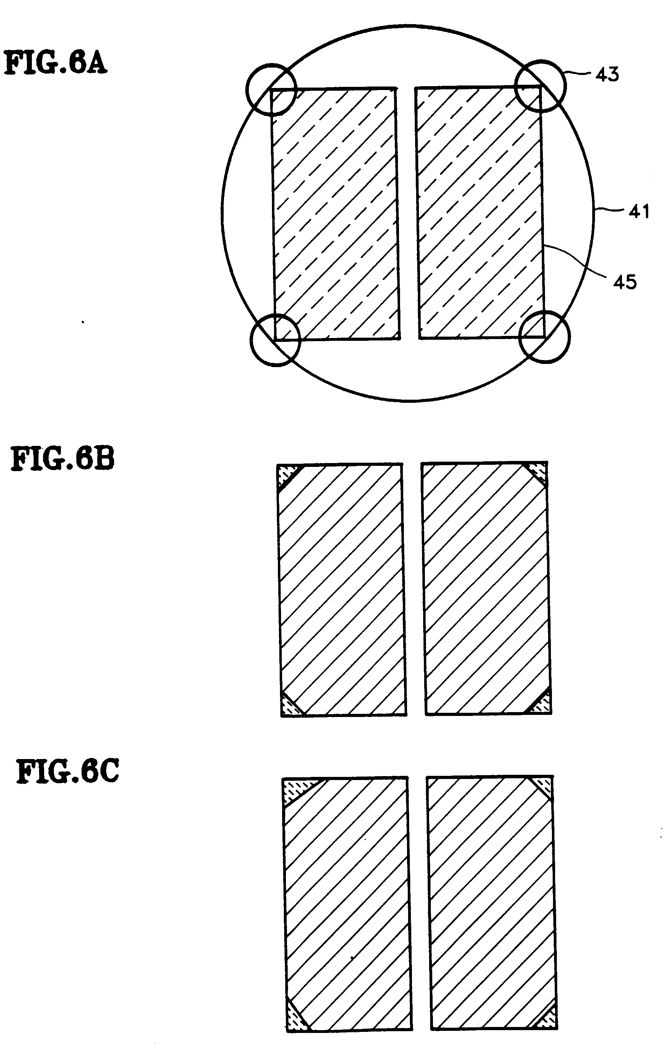

FIGS. 6A to 6C are views for explaining a method according to the present invention of adjusting line width change of a photoresist pattern generated by lens aberration of an exposing apparatus.

FIG. 6A shows a third region 43 indicating a part of a lens field 41 where the lens aberration is greater. In this case, where it is necessary to use all the lens field 41 due to the large size of a chip pattern 45 of a semiconductor device, a third region 43 exhibiting greater lens aberration is used for the corners of chip pattern 45. In such a case, light intensity at the portion exposed through third region 43 becomes greater than the other portions, which is undesirable. Thus, in a mask used for pattern formation according to the present invention, the above problem can be solved by forming the transmittance adjusting film pattern in a transmitting region of a portion exposed through third region 43.

FIG. 6B shows a mask which includes the transmittance adjusting film pattern for adjusting light intensity of a portion corresponding to the third region. When a pattern is formed by using the above mask, there will be no line width change of the photoresist pattern caused by the portion of greater lens aberration. This mask is made in the same method that is employed in making that of FIG. 5A. Meanwhile, FIG. 6C shows the arrangement of the transmittance adjusting film pattern at the mask, if the greater lens aberration portion is formed asymmetrically.

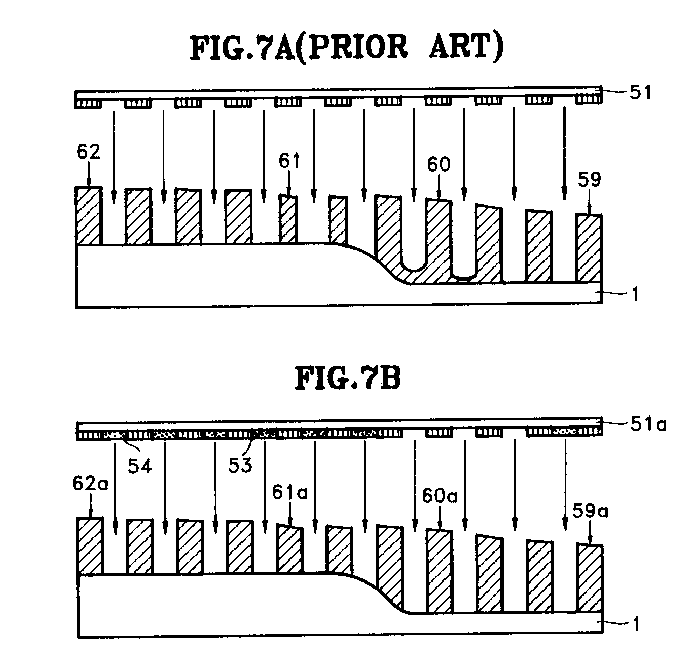

FIGS. 7A and 7B are views respectively showing a result of comparing the conventional method and that of the present invention with respect to an unevenness having the structure of FIG. 2.

In these cases, when a pattern is formed at the boundary portion where unevenness is generated by a lower pattern by using a first mask 51 according to the conventional method, plane portion patterns 59 and 62 formed on plane region 9 and 12, a lower portion pattern 60 formed on sunken portion 10 where the thickness of the photoresist is thick, and a protruded portion pattern 61 formed on protruding portion 11 where the thickness of the photoresist is thin, each exhibit different line widths. Furthermore, a bridge may occur between lower region patterns 60. However, in the case of using a first mask 51a according to an embodiment of the present invention, plane region patterns 59a and 62a, a lower region pattern 60a and a protruding region pattern 61a all have the same line width. Here, first mask 51a includes first and second transmittance adjusting film patterns 53 and 54. Accordingly, light passed through portions having different transmittances has different intensities. That is, the light intensity exposing lower region 10 is the highest; that exposing protruding region 11 is the lowest; those exposing plane regions 9 and 12 fall between. When the unevenness is not prominent, transmittance of first and second transmittance adjusting film patterns 53 and 54 can be made congruous, and a transmittance adjusting film pattern having a different transmittance may be formed in addition when the unevenness becomes more prominent.

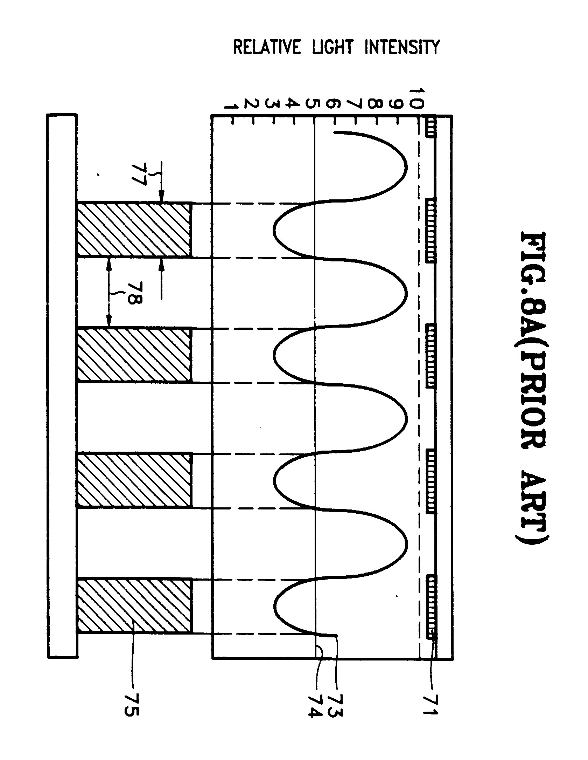

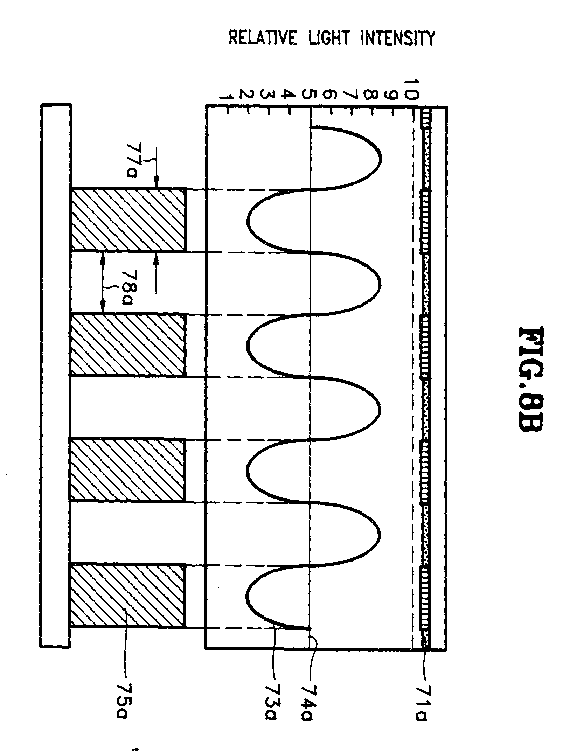

FIGS. 8A and 8B are graphs indicating the light intensity and the line width change of photoresist pattern in the conventional case and in embodiments of the present invention, respectively.

In detail, in the conventional case, when second mask 71 is used, the light intensity is as same as shown by strength curve 73 without change. Second mask pattern 75 formed to the standard of a threshold energy level 74 of the photoresist has a second mask pattern line width 77 and a second mask pattern interval 78. In contrast, light passed through second mask 71a of the present invention exhibits reduced light intensity - a drop in light intensity curve 73a. Thus, second mask pattern 75a has a second mask pattern line width 77a and second mask pattern interval 78a, these being of the same size.

As described above, in a forming method according to the present invention, the problem of line width change in the photoresist pattern is solved, so that a pattern adapted for use in a highly integrated semiconductor device can be formed by adjusting the light intensity.

It is noted that the present invention is not limited to the preferred embodiment described above, and it is apparent that variations and modifications by those skilled in the art can be effected within the scope of the present invention defined in the appended claims.

## Claims

1. A mask for use in photolithography comprising:
a transparent substrate;
a light-shielding pattern (31) for defining a transmitting region on said transparent substrate for transmitting light to a semiconductor substrate; and
a transmittance adjusting film pattern (32) added on a portion of the transmitting region for decreasing the transmittance of a first transmitting part for transmission of light to a first region of the semiconductor substrate with respect to the transmittance of a second transmitting part for transmission of light to a second region of the semiconductor substrate, said mask being adapted for use when the thickness of photoresist in the second region of the semiconductor substrate is greater than that in the first region of the semiconductor substrate.

2. A mask used in photolithography comprising:
a transparent substrate;
a light-shielding pattern for defining a transmitting region on said transparent substrate for transmitting light to a semiconductor substrate; and
a transmittance adjusting film pattern for reducing transmittance of a transmitting part adapted for transmission of light to a semiconductor substrate portion adapted to experience increased lens aberration from an exposing apparatus.

3. A mask used in photolithography according to claim 1 or 2, wherein the transmittance of said transmittance adjusting film pattern (32) is constant throughout said mask.

4. A mask used in photolithography according to claim 1 or claim 2, wherein the transmittance of said transmittance adjusting film (32) pattern (32) varies according to the position on said mask.

5. A mask used in photolithography according to any preceding claim, wherein the transmittance of said transmittance adjusting film pattern (32) is between 3-97%.

6. A mask used in photolithography according to any preceding claim, wherein said transmittance adjusting film pattern (32) is formed of a material selected from the group consisting of chromium (Cr), molybdenum (Mo), MoSi, MoSiO, MoSiON, CrO, CrON, amorphous carbon, dyed organic spin-on glass (SOG) and photoresist.
